# EUROPÄISCHE PATENTSCHRIFT

(11) **EP 2 047 715 B1**
(45) Veröffentlichungstag und Bekanntmachung des Hinweises auf die Patenterteilung: **09.06.2010**
(21) Anmeldenummer: 07785664.9
(22) Anmeldetag: 19.07.2007
(51) Int. Cl.: H05B 3/34, H05K 1/18, H05K 3/30

(54) **WIDERSTANDSANORDNUNG UND VERFAHREN ZU DEREN HERSTELLUNG**
RESISTOR ASSEMBLY AND METHOD FOR PRODUCING SAID ASSEMBLY
DISPOSITIF DE RÉSISTANCE ET PROCÉDÉ DE FABRICATION ASSOCIÉ

(30) Priorität: 20.07.2006 DE 102006033711
(43) Veröffentlichungstag der Anmeldung: 15.04.2009
(73) Patentinhaber: EPCOS AG, 81669 München (DE)
(72) Erfinder: IHLE, Jan, 8530 Deutschlandsberg (AT); KAHR, Werner, 8530 Deutschlandsberg (AT)
(74) Vertreter: Epping - Hermann - Fischer
(86) Internationale Anmeldenummer: PCT/DE2007/001296
(87) Internationale Veröffentlichungsnummer: WO 2008/009283

(56) Entgegenhaltungen:
- EP-A- 0 909 118
- WO-A-84/03586
- WO-A-98/10190
- WO-A-98/18615
- WO-A-2005/081602
- WO-A-2006/070658
- DE-U1- 29 922 947
- US-A- 4 368 380
- US-A- 5 534 061
- US-A1- 2003 047 549
- US-A1- 2004 262 644
- US-A1- 2006 102 615

## Beschreibung

Eine Widerstandsanordnung mit Körnchen aus PTC-Material, die in einem Bindemittel verteilt sind, ist aus der Druckschrift DE 3107290 A1 bekannt.

DE 299 22 947 U1 beschreibt eine Vorrichtung zur Wärmeisolierung, bei der mehrere keramische PTC-Widerstandskörper auf einer flexiblen Isolierunterlage angeordnet und mit einer Isolierschicht abgedeckt sind.

WO 98/10190 A beschreibt eine Anordnung von Heizelementen auf einer Unterlage aus einem Material, dessen Form sich temperaturabhängig verändert.

US 4,368,380 A beschreibt eine flexible Anordnung aus keramischen PTC-Heizsegmenten.

US 2004/262644 A1 beschreibt eine IC-Chip-Anordnung mit Verdrahtungen und Kontaktpads, die in ein Harz eingebettet sind.

WO 2005/081602 A1 und WO 2006/070658 A1 beschreiben die Verwendung eines Harzes zur Herstellung einer IC-Chip-Anordnung auf einem Träger.

Aus den Druckschriften WO 98/18615 A, EP 0909118 A2 und WO 84/03586 A sind Widerstandsanordnungen bekannt, bei denen Körnchen aus elektrisch leitfähigem Material in einem Bindemittel verteilt sind.

Eine zu lösende Aufgabe besteht darin, eine Widerstandsanordnung anzugeben, die zu einer effizienten Wärmeabgabe an eine gekrümmte Fläche geeignet ist.

Gemäß einer ersten bevorzugten Ausführungsform wird eine Widerstandsanordnung mit im Wesentlichen regelmäßig angeordneten Widerstandselementen angegeben, die durch ein gemeinsames flexibles Substrat miteinander verbunden sind. Zwischen den Widerstandselementen sind Zwischenräume angeordnet, die dafür vorgesehen sind, durch ein fließendes Medium durchströmt zu werden. Das fließende Medium ist vorzugsweise ein Fluid wie z. B. Luft, Öl, Wasser, ein anderes Gas oder eine andere Flüssigkeit.

Gemäß einer zweiten bevorzugten Ausführungsform wird eine Widerstandsanordnung mit im Wesentlichen regelmäßig angeordneten Widerstandselementen angegeben, die voneinander beabstandet sind. Die Widerstandselemente sind zwischen zwei flexiblen Substraten angeordnet und fest mit diesen verbunden.

Gemäß einer dritten bevorzugten Ausführungsform wird eine Widerstandsanordnung mit im Wesentlichen regelmäßig angeordneten Widerstandselementen angegeben, die voneinander beabstandet und durch ein gemeinsames flexibles Substrat miteinander verbunden sind. Zwischen den Widerstandselementen und dem Substrat ist eine elektrisch isolierende Haftschicht angeordnet, die Durchbrüche aufweist, durch die die Widerstandselemente mit dem Substrat leitend verbunden sind.

Gemäß einer vierten bevorzugten Ausführungsform wird eine Widerstandsanordnung mit im Wesentlichen regelmäßig angeordneten Widerstandselementen angegeben, die voneinander beabstandet und durch ein gemeinsames flexibles Substrat miteinander verbunden sind. Das Substrat umfasst als Grundmaterial einen elastischen Kunststoff, der mit elektrisch leitenden Partikeln gefüllt ist. Das Grundmaterial wie z. B. Silikonkautschuk kann dabei ein an sich elektrisch isolierendes Material sein, das durch das Hinzufügen der leitfähigen Partikel leitfähig gemacht wurde. Als Grundmaterial ist insbesondere ein Klebstoff wie z. B. Silikonkleber geeignet, das nach dem Aushärten flexibel bleibt.

Die bevorzugten Ausführungsformen können beliebig miteinander kombiniert werden.

Nachstehend werden vorteilhafte Ausgestaltungen der Widerstandsanordnung beschrieben, die für alle bevorzugten Ausführungsformen zutreffen.

Die Widerstandsanordnung ist vorzugsweise flächig ausgebildet. Die Widerstandselemente sind vorzugsweise flach ausgebildet. Das Substrat ist vorzugsweise biegsam, kann aber auch in Form einer starren Platte vorhanden sein.

Die Widerstandselemente sind vorzugsweise Keramikelemente, die einen vorzugsweise massiv ausgebildeten, starren, gesinterten Keramikkörper umfassen. Der Keramikkörper kann als eine Widerstandsschicht ausgebildet sein. Der Keramikkörper weist vorzugsweise PTC-Eigenschaften auf. PTC steht für Positive Temperature Coefficient. Als PTC-Material ist beispielsweise eine PTC-Keramik auf der Basis von BaTiO₃ geeignet.

In einer vorteilhaften Variante sind die Widerstandselemente als Heizelemente vorgesehen. Die Widerstandsanordnung ist vorzugsweise eine Heizvorrichtung.

In einer weiteren Variante sind die Widerstandselemente als Sensorelemente vorgesehen. Sensorelemente sind zur Erfassung einer physikalischen Größe wie z. B. Temperatur geeignet. Die Widerstandsanordnung ist in diesem Fall eine Sensorvorrichtung.

Die Widerstandselemente weisen vorzugsweise eine ebene oder glatte Oberfläche auf. Sie sind vorzugsweise flächig (plattenförmig) ausgebildet, wobei die laterale Querschnittsgröße des jeweiligen Widerstandselements seine Höhe übersteigt. Die Widerstandselemente sind vorzugsweise rechteckig und insbesondere quadratisch ausgebildet. Die Widerstandselemente können aber eine beliebige andere Grundform, z. B. diejenige eines Mehrecks oder Kreises, aufweisen.

Zwischen zwei benachbarten Widerstandselementen ist vorzugsweise ein Spalt (vorzugsweise ein Luftspalt) angeordnet, dessen Breite vorzugsweise kleiner als die laterale Querschnittsgröße eines Widerstandselements ist.

Die Widerstandselemente sind vorzugsweise derart regelmäßig angeordnet, dass zwischen ihnen Spalten in Form von Kanälen gebildet sind. Diese Spalten können durch ein strömendes Medium wie z. B. Flüssigkeit oder Gas gefüllt sein. Die relative Anordnung und Breite der Spalten ist vorzugsweise so gewählt, dass sie ein durchströmbares Netzwerk (Perkolationsnetzwerk) bilden. Die Spalten sind vorzugsweise derart miteinander verbunden, dass die Spaltenanordnung frei von "Sackgassen" ist. Die Widerstandselemente bilden vorzugsweise eine regelmäßige, zweidimensionale Anordnung in einer Lateralebene, falls die Widerstandsanordnung auf einer ebenen Unterlage aufliegt. Eine solche Anordnung kann in einer Variante mehrere Reihen und Spalten aufweisen. Eine Schachbrettanordnung ist auch möglich.

Das flexible Substrat besteht vorzugsweise aus einem thermisch hochleitfähigen Material, dessen Wärmeleitfähigkeit vorzugsweise höher ist als diejenige der Widerstandselemente. Somit wird eine gute thermische Verbindung der Widerstandselemente gewährleistet.

Das flexible Substrat stellt in einer vorteilhaften Variante eine dünne, flexible Folie dar, die reißfest ist. Das flexible Substrat ist vorzugsweise nicht formfest und in dem Maße formveränderlich (biegsam), dass es beim Auflegen auf eine nicht ebene Oberfläche ohne Kraftanwendung im Wesentlichen die Form dieser Oberfläche annimmt.

Durch das flexible Substrat ist eine im Wesentlichen formschlüssige Anordnung der Widerstandsanordnung auf der zu heizenden Oberfläche möglich. Die Größe der Widerstandselemente ist um so kleiner zu wählen, je größer die Krümmung der zu beheizenden Oberfläche ist.

Das Substrat ist vorzugsweise elastisch. Das Substrat kann z. B. eine gummiartige Folie umfassen. Beliebige organische Polymere als Material für das Substrat kommen dabei in Betracht. Das Substrat kann z. B. Kautschuk, insbesondere Silikonkautschuk umfassen.

Das flexible Substrat kann beispielsweise Ni-, Cr-, Ag-, Cu-, Al- oder andere Metallpartikel umfassen. Das flexible Substrat kann auch mindestens eine Metallschicht - vorzugsweise eine Cr, Ni oder Cr/Ni Schicht - umfassen.

Auf die Hauptflächen der Widerstandsschicht ist vorzugsweise eine Metallschicht zur Bildung von Elektroden des Widerstandselements aufgetragen, die sich zur Kontaktierung von Widerstandselementen eignet, wie z. B. Cr, Ni, Al, Zn, Ag. Jedes Widerstandselement weist vorzugsweise eine erste und eine zweite Elektrode auf.

Die ersten Elektroden der Widerstandselemente können durch einen leitfähigen Bereich eines flexiblen ersten Substrats elektrisch miteinander verbunden sein. Die zweiten Elektroden der Widerstandselemente können durch einen leitfähigen Bereich eines flexiblen zweiten Substrats elektrisch miteinander verbunden sein.

Der leitfähige Bereich des jeweiligen Substrats kann durch eine leitfähige Teilschicht des Substrats gebildet sein. Das Substrat kann außerdem mindestens eine elektrisch isolierende Teilschicht umfassen, die vorzugsweise nach außen gewandt und von den Widerstandelementen abgewandt ist. Der leitfähige Bereich kann auch durch einen mit Metallpartikeln gefüllten Bereich des Substrats gebildet sein. Der leitfähige Bereich kann alternativ durch mindestens einen Draht gebildet sein, der in einem elektrisch isolierenden Grundmaterial des Substrats eingelassen ist. Der mindestens einen Draht umfasst vorzugsweise ein Drahtgeflecht.

Die ersten Elektroden der Widerstandselemente können mittels Zuleitungen leitend miteinander verbunden sein, die im Substrat integriert oder auf der Oberfläche des Substrats angeordnet sind. Die zweiten Elektroden der Widerstandselemente können auch auf diese Art und Weise leitend miteinander verbunden sein. Die zweiten Elektroden können aber auch durch eine elektrisch leitende Fläche elektrisch verbunden werden, die die Widerstandsanordnung berührt, aber nicht Bestandteil dieser Anordnung ist. Die elektrische Kontaktierung der zweiten Elektroden von Widerstandselementen kann beispielsweise durch ein leitfähiges zu heizendes Objekt erfolgen, an das die zweiten Hauptflächen der Widerstandselemente anzupressen sind.

Die elektrische Kontaktierung der ersten Elektroden von Widerstandselementen über das gemeinsame Substrat ist außerdem möglich, wenn dieses Substrat mindestens eine elektrisch leitende Schicht - z. B. eine kupferhaltige Metallschicht - umfasst. Das Substrat kann eine elektrisch isolierende, vorzugsweise elastische Folie umfassen, die mit der Metallschicht beschichtet ist. Die Metallschicht kann als Metallkaschierung, vorzugsweise eine Kupferkaschierung, ausgebildet sein. Das Substrat kann im Prinzip alternativ eine selbsttragende Metallfolie umfassen, die vorzugsweise in ein flexibles Substrat wie z. B. Silikonsubstrat eingebettet ist.

Die Metallschicht und die Widerstandselemente sind vorzugsweise mittels einer Haftschicht miteinander verbunden, die im Bereich von jedem Widerstandselement zumindest einen Durchbruch aufweist, durch den die Metallschicht die Hauptfläche des jeweiligen Widerstandselements elektrisch kontaktieren kann. Dieser Durchbruch stellt eine Durchkontaktierung durch die Haftschicht dar.

Das flexible Substrat kann als Horde, d. h. Gitter mit Ausnehmungen zur Aufnahme von Widerstandselementen, ausgebildet sein. Die Ausnehmungen sind vorzugsweise als Durchbrüche ausgebildet. Die Dicke der Widerstandselemente übersteigt in einer Variante diejenige des Substrats. Die Widerstandselemente ragen aus dem Substrat vorzugsweise beidseitig heraus. Auf zumindest einer der Hauptflächen der Widerstandsanordnung können die Widerstandselemente zusätzlich, wie bereits beschrieben, durch ein weiteres Substrat miteinander verbunden sein, das einen elektrisch leitfähigen Bereich aufweist. Vorzugsweise ist auf jeder Seite der Widerstandsanordnung ein solches Substrat vorgesehen.

Bei der Widerstandsanordnung gemäß der zweiten, dritten und vierten Ausführungsform können die zwischen den Widerstandselementen vorhandenen Spalte durch ein flexibles, elektrisch isolierendes Material ausgefüllt sein. Beispielsweise können die ersten Hauptflächen der Widerstandselemente durch ein leitendes Silikonsubstrat mechanisch, thermisch und elektrisch miteinander verbunden sein, wobei die Zwischenräume zwischen den Widerstandselementen mit einem elektrisch isolierenden, aber thermisch gut leitenden Silikon oder einem anderen flexiblen Material ausgefüllt sind. Das thermisch gut leitende Material weist vorzugsweise eine bessere thermische Leitfähigkeit als der Körper des Widerstandselements auf. Somit kann gegenüber einem mit Luft oder Gas gefüllten Spalt die thermische Anbindung zwischen den Widerstandselementen verbessert werden. Dieses Material kann ein ausgehärtetes Silikon oder ein anderes gummiartiges Material sein. Dieses Material kann auch flüssig, dickflüssig oder gelartig sein. Eine biegsame Widerstandsanordnung kann beispielsweise in einem Verfahren mit den folgenden Schritten hergestellt werden. Zunächst wird eine flexible Folie mit einer Platte verbunden, die PTC-Material umfasst. Die Hauptflächen der Platten sind vorzugsweise metallisiert. Die Platte wird entlang Trennlinien derart zertrennt, dass die flexible Folie nicht durchgeschnitten wird. Dafür wird vorzugsweise eine harte Unterlage und eine Präzisionssäge verwendet.

Ein alternatives Verfahren weist die folgenden Schritte auf. Zunächst wird ein elastisches Substrat mit regelmäßig angeordneten, vorgefertigten Durchbrüchen und eine Vielzahl von (vereinzelten) plattenförmigen Widerstandselementen bereitgestellt. Die plattenförmigen Widerstandselemente werden in die Durchbrüche der Folie hineingesetzt. Die ersten Hauptflächen der Widerstandselemente werden mit einer flexiblen Abdeckung verbunden. Unter Umständen werden auch die zweiten Hauptflächen der Widerstandselemente mit einer weiteren flexiblen Abdeckung verbunden.

Die angegebene Widerstandsanordnung sowie das Verfahren zu deren Herstellung wird nun anhand von schematischen und nicht maßstabgetreuen Figuren erläutert. Es zeigen:
Figur 1 im Querschnitt einen Verbund des flexiblen Substrats und der Keramikplatte, die Widerstandselemente umfasst, vor dem Vereinzeln der Widerstandselemente;
Figur 2 im Querschnitt die Widerstandsanordnung nach dem Vereinzeln der Widerstandselemente;
Figur 3 in einer Draufsicht die Widerstandsanordnung gemäß Figur 2 nach dem Vereinzeln der Widerstandselemente;
Figur 4 im Querschnitt die Widerstandsanordnung gemäß Figur 2, die an ein zu heizendes Objekt mit einer krummen Oberfläche angepresst ist;
Figur 5 im Querschnitt eine Widerstandsanordnung gemäß der dritten bevorzugten Ausführungsform;
Figur 6 im Querschnitt eine Widerstandsanordnung mit Widerstandselementen, die zwischen zwei flexiblen Substraten angeordnet sind, gemäß der zweiten bevorzugten Ausführungsform;
Figur 7 im Querschnitt die Widerstandsanordnung gemäß Figur 6, die an ein zu heizendes Objekt mit einer krummen Oberfläche angepresst ist;
Figur 8 eine Variante der in Fig. 6 vorgestellten Widerstandsanordnung, wobei die Substrate jeweils eine elektrisch isolierende Trägerfolie und eine Metallschicht umfassen;
Figur 9 im Querschnitt eine Widerstandsanordnung mit einem flexiblen Substrat, in dem regelmäßig angeordnete Durchbrüche zur Aufnahme von Widerstandselementen ausgebildet sind.

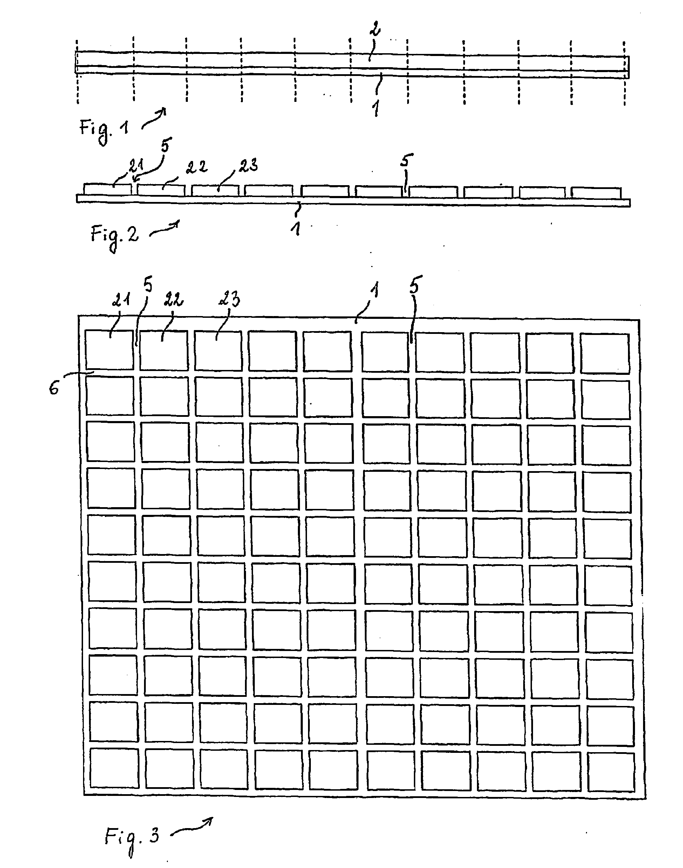

Figur 1 zeigt eine Keramikplatte 2, die mit einem Substrat 1 einen Verbund bildet. Die Dicke der Keramikplatte 2 übersteigt diejenige des Substrats 1.

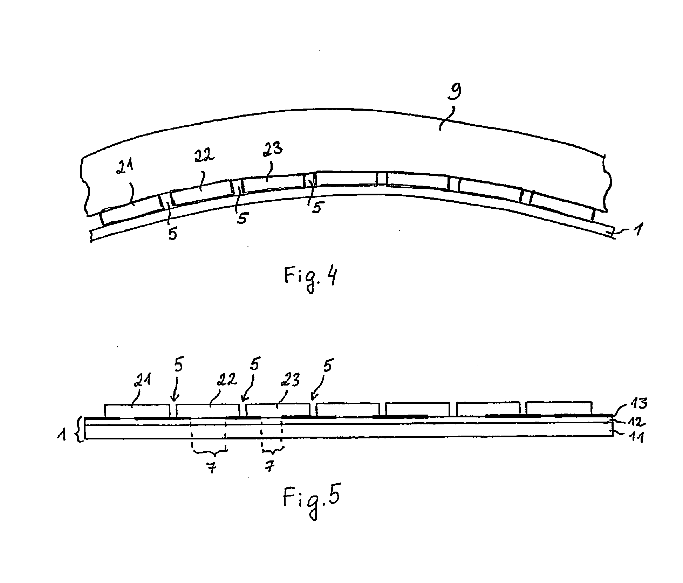

Das Substrat 1 kann als eine vorzugsweise dickflüssige Schicht auf die Keramikplatte 2 aufgetragen werden. Diese Schicht bildet nach dem Aushärten einen Verbund mit der Keramikplatte. Die Keramikplatte und das Substrat können aber auch wie in Figur 5 angedeutet durch Verkleben miteinander verbunden werden.

Mit gestrichelten Linien sind Trennlinien angedeutet. Die Keramikplatte 2 soll entlang dieser Linien zur Vereinzelung von in Figur 2 gezeigten Widerstandselementen 21, 22, 23 zersägt werden. Das Substrat 1 wird dabei vorzugsweise zwar angesägt, aber nicht zersägt. Nach der Vereinzelung entsteht eine in Figuren 2 und 3 gezeigte Widerstandsanordnung. Die Widerstandselemente 21, 22, 23 sind in erster Lateralrichtung durch Spalte 5 und in zweiter Lateralrichtung durch Spalte 6 voneinander getrennt. Die Spalte 6 können in einer Variante entfallen.

Die Widerstandselemente bilden eine regelmäßige Anordnung, die Reihen und Spalten aufweist (Fig. 3). Die Breite der zwischen den Widerstandselementen angeordneten Spalten ist in diesem Beispiel deutlich kleiner als die Breite der Widerstandselemente.

Jedes Widerstandselement 21, 22, 23 weist an seinen Hauptflächen angeordnete Metallschichten und eine zwischen diesen angeordnete Widerstandsschicht auf. Die Metallschichten dienen als Elektroden des jeweiligen Widerstandselements. Erste, in Fig. 2 untere Elektroden der Widerstandselemente 21, 22, 23 usw. sind durch das in diesem Fall elektrisch leitfähige Substrat 1 leitend miteinander verbunden.

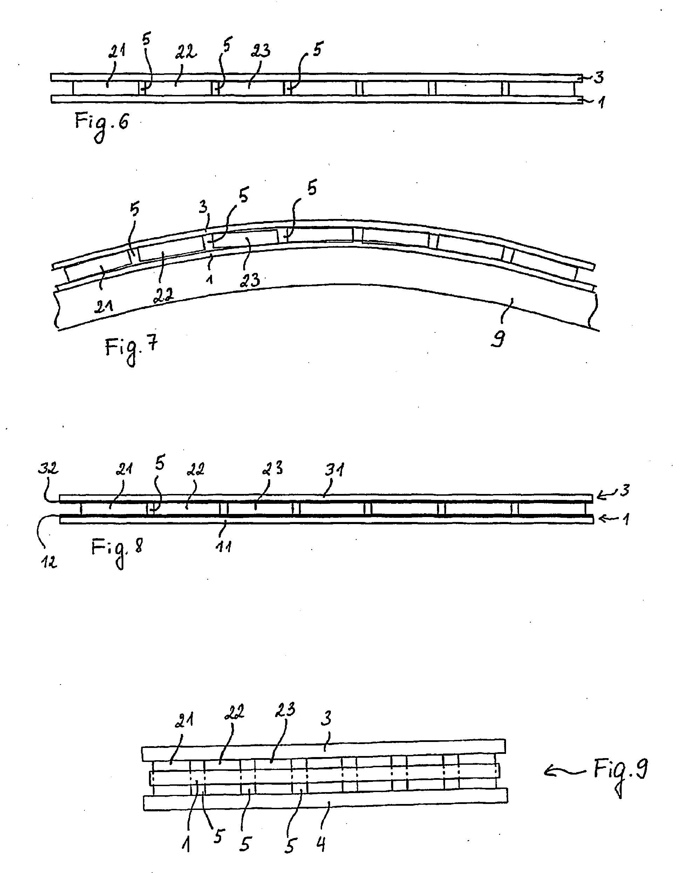

Jeder Spalt 5, 6 stellt einen Kanal dar. Die Spalte sind vorzugsweise Luftspalte. Sie können aber auch wie im Beispiel gemäß Figur 9 zumindest teilweise mit einem elektrisch isolierenden Material gefüllt sein, das einen Kurzschluss zwischen ersten und zweiten Elektroden der Widerstandselemente verhindert.

In Figur 4 ist die Widerstandsanordnung gemäß den Figuren 2 und 3 an ein zu heizendes Objekt 9 angepresst. Das Objekt 9 weist eine krumme Oberfläche auf.

In der in Figur 4 gezeigten Variante ist das zu heizende Objekt 9 elektrisch leitfähig. In diesem Fall werden die ursprünglich nicht miteinander verbundenen zweiten Elektroden der Widerstandselemente über dieses Objekt leitend miteinander verbunden. Alternativ können die zweiten Elektroden der Widerstandselemente durch die in Figur 6 gezeigte, elektrisch leitfähige flexible Abdeckung 3 leitend verbunden sein. Diese Abdeckung ist vorzugsweise aus dem gleichen Material wie das Substrat 1 ausgebildet.

In Figur 7 ist die Widerstandsanordnung gemäß der Figur 6 gezeigt, die an das zu heizende Objekt 9 mit einer krummen Oberfläche angepresst ist.

In der Figur 5 ist eine weitere Variante vorgestellt, bei der das Substrat 1 eine flexible, vorzugsweise elektrisch isolierende Trägerfolie 11 und eine Metallschicht 12 umfasst. Das Substrat 1 und die Widerstandselemente 21, 22, 23 sind miteinander mittels einer elektrisch isolieneden Haftschicht 13 verbunden. Diese Haftschicht weist Durchbrüche 7 auf, die jeweils als eine Durchkontaktierung wirken. Die Dicke der Haftschicht 13 wird so gewählt, dass sichergestellt ist, dass beim Zusammenpressen des Substrats 1 und der Keramikplatte 2 im Bereich eines jeden Widerstandselements mindestens ein solcher Durchbruch gebildet wird. Folglich sind die Widerstandselemente trotz der Haftschicht 13 alle leitend mit der Metallschicht 12 des Substrats 1 verbunden.

In der Figur 8 ist eine weitere Ausführung gezeigt, die eine Kombination der Varianten gemäß den Figuren 5 und 6 darstellt. Die Abdeckung 3 weist eine flexible Trägerfolie 31 und eine auf diese aufgetragene Metallschicht 32 auf, welche - ähnlich wie die Metallschicht 12 - die zweiten Elektroden der Widerstandselemente leitend miteinander verbindet.

Das Substrat 1 sowie jede in Figuren 6 bis 9 gezeigte Abdeckung 3, 4 sorgt für die mechanische, thermische und ggf. elektrische Verbindung der einzelnen Widerstandselemente 21, 22, 23 usw. Das Substrat 1 und die Abdeckung 3 (oder die Abdeckungen 3, 4 in Fig. 9) berühren einander nicht, um einen Kurzschluss zwischen elektrischen Anschlüssen der Widerstandsanordnung zu vermeiden.

In den Varianten gemäß den Figuren 6 und 8 ist es vorteilhaft, wenn die Abdeckung 3 die gleiche Zusammensetzung und Dicke wie das Substrat 1 aufweist. Möglich ist aber auch, dass das Substrat und die Abdeckung zwar das gleiche Material, aber unterschiedliche Dicken aufweisen. Die Verwendung von unterschiedlichen Materialien für das Substrat und die Abdeckung ist auch möglich.

In der Variante gemäß der Figur 9 ist das Substrat 1 mit regelmäßig angeordneten Durchbrüchen ausgebildet. Die Anordnung der Durchbrüche bildet ein Lochraster und entspricht in etwa der in Figur 3 bereits erläuterten Anordnung der Widerstandselemente. In jeden Durchbruch wird ein Widerstandselement eingesteckt.

Das Substrat umfasst vorzugsweise eine elastische, elektrisch isolierende Folie. Die Form von jedem Durchbruch ist vorzugsweise an die Form des in diesen Durchbruch einzufügenden Widerstandselements 21, 22, 23 angepasst. Die Größe von diesen Durchbrüchen ist vorzugsweise jedoch etwas kleiner als diejenige der Widerstandselemente, damit das Widerstandselement darin durch elastische Kräfte gehalten werden kann.

Auf beide Seiten der mit dem Substrat 1 verbundenen Anordnung der Widerstandselemente 21, 22, 23 usw. ist eine Abdeckung 3, 4 aufgetragen. Diese Abdeckungen können jeweils wie die in der Variante gemäß der Figur 6 erläuterte Abdeckung 3 ausgebildet sein.

In der Variante gemäß der Figur 9 ist es vorteilhaft, wenn die Abdeckung 4 die gleiche Zusammensetzung und Dicke wie die vorstehend erläuterte Abdeckung 3 aufweist. Möglich ist aber auch, dass beide Abdeckungen 3, 4 zwar das gleiche Material, aber unterschiedliche Dicken aufweisen. Die Verwendung von unterschiedlichen Materialien ist im Prinzip auch möglich.

In der Variante gemäß der Figur 9 ist die Dicke der Widerstandselemente 21, 22, 23 größer als diejenige des Substrats 1. Die Widerstandselemente ragen aus dem Substrat 1 auf beiden Seiten (in Fig. 9 oben und unten) hinaus, so dass die Hauptflächen der Widerstandselemente frei liegen, wobei zwischen den Seitenflächen der Widerstandselemente auf beiden Seiten der Widerstandsanordnung ein ungefüllter Zwischenraum vorhanden ist.

In Fig. 9 ist der Spalt 5 zwischen den Widerstandselementen 21, 22, 23 nur teilweise durch das Substrat 1 ausgefüllt. Der restliche Teil des Spaltes 5 kann im Prinzip mit Luft oder Gas gefüllt sein. Es besteht aber auch die Möglichkeit, den verbleibenden Zwischenraum, der zwischen der Abdeckung 3, 4, dem Substrat 1 und den Widerstandselementen 21, 22, 23 angeordnet ist, mit einem flexiblen Material zu füllen. Dieses Material kann auch flüssig oder dickflüssig sein. Dies trifft auch auf die Ausführungen gemäß den Figuren 6 und 8 zu.

In einer Abwandlung der in Figur 9 gezeigten Variante kann auf die zweite Abdeckung 4 verzichtet werden.

### Bezugszeichenliste

- 1: flexibles Substrat
- 11: Trägerfolie
- 12: Metallschicht
- 13: Haftschicht
- 2: Keramikplatte
- 21, 22, 23: Widerstandselemente
- 3: erste Abdeckung
- 31: Trägerfolie
- 32: Metallschicht
- 4: zweite Abdeckung
- 5: Spalt
- 6: Spalt
- 7: Durchbruch durch die Haftschicht 13
- 9: zu heizendes Objekt

## Patentansprüche

1. Widerstandsanordnung
- umfassend im Wesentlichen regelmäßig angeordnete, voneinander beabstandet Widerstandselemente (21, 22, 23), die zwischen zwei flexiblen Substraten (1, 3) angeordnet und fest mit diesen verbunden sind,
**dadurch gekennzeichnet,**
**dass** die zwischen den Widerstandselementen (21, 22, 23) gebildeten Zwischenräume ein in Flussrichtung durchlässiges durchströmbares Netzwerk bilden, das in Dickenrichtung der Anordnung durch zwei Begrenzungsflächen hermetisch abgedichtet ist, wobei die Begrenzungsflächen durch flexible Substrate (1) gebildet sind.

2. Widerstandsanordnung nach Anspruch 1,
- wobei zwischen den Widerstandselementen (21, 22, 23) und dem Substrat (1) eine elektrisch isolierende Haftschicht (13) angeordnet ist, die Durchbrüche aufweist, durch die die Widerstandselemente (21, 22, 23) mit dem Substrat (1) leitend verbunden sind.

3. Widerstandsanordnung nach einem der Ansprüche 1 bis 2,
- wobei das Substrat (1) als Grundmaterial einen elastischen Kunststoff umfasst, der mit elektrisch leitenden Partikeln gefüllt ist.

4. Widerstandsanordnung nach einem der Ansprüche 1 bis 3,
- wobei zwischen den Widerstandselementen (21, 22, 23) Zwischenräume in Form von Kanälen vorgesehen sind.

5. Widerstandsanordnung nach einem der Ansprüche 1 bis 4,
- wobei die Zwischenräume zumindest teilweise mit einem elektrisch nicht leitenden Material gefüllt sind.

6. Widerstandsanordnung nach einem der Ansprüche 1 bis 5, wobei erste Elektroden von Widerstandselementen (21, 22, 23) leitend miteinander verbunden sind.

7. Widerstandsanordnung nach Anspruch 6,
- wobei die Widerstandselemente (21, 22, 23) jeweils einen Keramikkörper mit PTC-Eigenschaften umfassen,
- wobei für jedes Widerstandselement (21, 22, 23) gilt, dass die erste Elektrode an der ersten Hauptfläche des Keramikkörpers angeordnet ist.

8. Widerstandsanordnung nach einem der Ansprüche 1 bis 7,
- wobei das Substrat (1) eine Folie (11) mit elastischen Eigenschaften umfasst.

9. Widerstandsanordnung nach Anspruch 1,
- wobei das Substrat (1) eine Metallschicht (12) umfasst, die auf einer elektrisch isolierenden Folie (11) angeordnet ist,
- wobei die Metallschicht (12) und die Widerstandselemente (21, 22, 23) mittels einer Haftschicht (13) miteinander verbunden sind, die in zumindest einigen Bereichen Durchbrüche aufweist, durch welche die Metallschicht (12) die Widerstandselemente (21, 22, 23) elektrisch kontaktiert.

10. Widerstandsanordnung nach einem der Ansprüche 1 bis 9,
- wobei die Widerstandselemente (21, 22, 23) mindestens eine Reihe oder Spalte bilden.

11. Widerstandsanordnung nach einem der Ansprüche 1 bis 10,
- wobei das Substrat (1) Durchbrüche aufweist, in denen die Widerstandselemente (21, 22, 23) angeordnet sind.

12. Widerstandsanordnung nach einem der Ansprüche 1 bis 11,
- wobei die Dicke des Substrats (1) diejenige der Widerstandselemente (21, 22, 23) unterschreitet.

13. Widerstandsanordnung nach einem der Ansprüche 1 bis 2,
- wobei zumindest ein Bereich des Substrats (1, 3) elektrisch leitfähig ist,
- wobei erste Elektroden der Widerstandselemente (21, 22, 23) mittels des leitfähigen Bereichs des Substrats (1, 3) elektrisch miteinander verbunden sind.

14. Widerstandsanordnung nach Anspruch 13,
- wobei der leitfähige Bereich des Substrats (1, 3) als eine Metallschicht ausgebildet ist, die auf einer elektrisch isolierenden, flexiblen Trägerfolie angeordnet ist.

## Claims

1. Resistor assembly
- comprising substantially regularly arranged, spaced-apart resistor elements (21, 22, 23), which are arranged between two flexible substrates (1, 3) and are firmly connected thereto, **characterized in that** the interspaces formed between the resistor elements (21, 22, 23) form a network which is permeable in the direction of flow, allows a flow to pass through and is hermetically sealed in the direction of the thickness of the assembly by two bounding surfaces, the bounding surfaces being formed by flexible substrates (1).

2. Resistor assembly according to Claim 1,
- an electrically insulating bonding layer (13) being arranged between the resistor elements (21, 22, 23) and the substrate (1) and having openings through which the resistor elements (21, 22, 23) are conductively connected to the substrate (1).

3. Resistor assembly according to either of Claims 1 and 2,
- the substrate (1) comprising an elastic plastic, filled with electrically conducting particles, as the base material.

4. Resistor assembly according to one of Claims 1 to 3,
- interspaces in the form of channels being provided between the resistor elements (21, 22, 23).

5. Resistor assembly according to one of Claims 1 to 4,
- the interspaces being at least partially filled with an electrically nonconducting material.

6. Resistor assembly according to one of Claims 1 to 5,
- first electrodes of resistor elements (21, 22, 23) being conductively connected to one another.

7. Resistor assembly according to Claim 6,
- the resistor elements (21, 22, 23) respectively comprising a ceramic body with PTC properties,
- the first electrode of each resistor element (21, 22, 23) being arranged on the first main surface of the ceramic body.

8. Resistor assembly according to one of Claims 1 to 7,
- the substrate (1) comprising a sheet (11) with elastic properties.

9. Resistor assembly according to Claim 1,
- the substrate (1) comprising a metal layer (12), which is arranged on an electrically insulating sheet (11),
- the metal layer (12) and the resistor elements (21, 22, 23) being connected to one another by means of a bonding layer (13), which has in at least some regions openings through which the metal layer (12) electrically contacts the resistor elements (21, 22, 23).

10. Resistor assembly according to one of Claims 1 to 9,
- the resistor elements (21, 22, 23) forming at least one row or column.

11. Resistor assembly according to one of Claims 1 to 10,
- the substrate (1) having openings in which the resistor elements (21, 22, 23) are arranged.

12. Resistor assembly according to one of Claims 1 to 11,
- the thickness of the substrate (1) being less than that of the resistor elements (21, 22, 23).

13. Resistor assembly according to either of Claims 1 and 2,
- at least one region of the substrate (1, 3) being electrically conductive,
- first electrodes of the resistor elements (21, 22, 23) being electrically connected to one another by means of the conductive region of the substrate (1, 3).

14. Resistor assembly according to Claim 13,
- the conductive region of the substrate (1, 3) being formed as a metal layer which is arranged on an electrically insulating, flexible carrier sheet.

## Revendications

1. Ensemble de résistances comprenant:
des éléments de résistance (21, 22, 23) disposés régulièrement, situés à distance les uns des autres entre deux substrats flexibles (1, 3) et reliés solidairement à ces derniers,
**caractérisé en ce que**
les espaces intermédiaires formés entre les éléments de résistance (21, 22, 23) forment un réseau perméable apte à être traversé dans la direction d'écoulement et fermé hermétiquement dans le sens de l'épaisseur de l'ensemble par deux surfaces frontières et
**en ce que** les surfaces frontières sont formées par des substrats flexibles (1).

2. Ensemble de résistances selon la revendication 1, dans lequel une couche adhérente (13) électriquement isolante qui présente des perforations par lesquelles les éléments de résistance (21, 22, 23) sont reliés de manière conductrice au substrat (1) est disposée entre les éléments de résistance (21, 22, 23) et le substrat (1).

3. Ensemble de résistances selon l'une des revendications 1 à 2, dans lequel le substrat (1) comprend comme matériau de base une matière synthétique élastique chargée de particules électriquement conductrices.

4. Ensemble de résistances selon l'une des revendications 1 à 3, dans lequel des espaces intermédiaires qui présentent la forme de canaux sont prévus entre les éléments de résistance (21, 22, 23).

5. Ensemble de résistances selon l'une des revendications 1 à 4, dans lequel les espaces intermédiaires sont remplis au moins en partie d'un matériau électriquement non conducteur.

6. Ensemble de résistances selon l'une des revendications 1 à 5, dans lequel les premières électrodes des éléments de résistance (21, 22, 23) sont reliées de manière conductrice les unes aux autres.

7. Ensemble de résistances selon la revendication 6, dans lequel les éléments de résistance (21, 22, 23) comprennent tous un corps en céramique à propriétés PTC, la première électrode étant disposée sur la première surface principale du corps en céramique de chaque élément de résistance (21, 22, 23).

8. Ensemble de résistances selon l'une des revendications 1 à 7, dans lequel le substrat (1) présente une feuille (11) à propriétés élastiques.

9. Ensemble de résistances selon la revendication 1, dans lequel le substrat (1) comprend une couche métallique (12) disposée sur une feuille (11) électriquement isolante, la couche métallique (12) et les éléments de résistance (21, 22, 23) étant reliés les uns aux autres au moyen d'une couche adhésive (13) qui présente dans au moins certaines de ses parties des perforations par lesquelles la couche métallique (12) est mise en contact électrique avec les éléments de résistance (21, 22, 23).

10. Ensemble de résistances selon l'une des revendications 1 à 9, dans lequel les éléments de résistance (21, 22, 23) forment au moins une ligne ou une colonne.

11. Ensemble de résistances selon l'une des revendications 1 à 10, dans lequel le substrat (1) présente des perforations dans lesquelles les éléments de résistance (21, 22, 23) sont placés.

12. Ensemble de résistances selon l'une des revendications 1 à 11, dans lequel l'épaisseur du substrat (1) est inférieure à celle des éléments de résistance (21, 22, 23).

13. Ensemble de résistances selon l'une des revendications 1 à 2, dans lequel au moins une partie du substrat (1, 3) est électriquement conductrice, des premières électrodes des éléments de résistance (21, 22, 23) étant reliées électriquement les unes aux autres au moyen de la partie conductrice du substrat (1, 3).

14. Ensemble de résistances selon la revendication 13, dans lequel la partie conductrice du substrat (1, 3) est formée d'une couche métallique qui est disposée sur une feuille flexible de support électriquement isolante.
